# EUROPEAN PATENT APPLICATION

(11) **EP 1 811 735 A1**
(43) Date of publication of application: **25.07.2007**
(21) Application number: 06020959.0
(22) Date of filing: 05.10.2006
(51) Int. Cl.: H04L 27/36, H03L 7/197

(54) **Wireless transceiver with modulation path delay calibration**

(30) Priority: 17.01.2006 US 333729
(71) Applicant: Broadcom Corporation, Irvine, CA 92617 (US)
(72) Inventor: Darabi, Hooman, Irvine California 92618-7013 (US); Jensen, Henrik, Tholstrup, Irvine California 92618-7013 (US); Zolfaghari, Alireza, Irvine California 92618-7013 (US)
(74) Representative: Jehle, Volker Armin

(57) **Abstract**

Various embodiments are disclosed relating to wireless systems, and relating to wireless transceivers. In an example embodiment, the wireless transceiver may include a voltage controlled oscillator (VCO) that may be controlled by a phase-locked loop (PLL). A fractional-N divider may be coupled to a feedback loop of the PLL and a delta-sigma modulator may control the fractional-N divider to vary the divider number of the fractional-N divider to cause the VCO to output a modulated frequency spectrum. In another embodiment, modulation path calibration may be performed by inputting an amplitude and phase modulated transmit spectrum to the transceiver's receiver to be demodulated. The demodulated transmit spectrum may then be analyzed to determine if the transmit spectrum meets one or more signal requirements, such as falling within a required spectral mask. The AM path delay and/or the PM path delay of the transmitter may be adjusted to decrease a mismatch in timing or delay between the AM and PM paths.

## Description

### BACKGROUND

Wireless transceivers are used in a wide variety of wireless systems. A wireless transceiver may typically include a wireless receiver for receiving and demodulating signals, and a transmitter for modulating signals for transmission. A variety of different modulation techniques may be used, such as those involving amplitude modulation, phase modulation, frequency modulation, or variations or combinations thereof. Wireless transceivers may be capable of transmitting on different frequencies or bands.

### SUMMARY

Various embodiments are disclosed relating to wireless systems, and also relating to wireless transceivers with a modulation path delay calibration.

According to an example embodiment, an apparatus is provided that includes a wireless transceiver that includes a voltage controlled oscillator (VCO) to output one or more frequency signals. A phase-locked loop (PLL) may be provided to control the VCO. A fractional-N divider may be coupled to a feedback loop of the PLL to divide the frequency signal output by the VCO by a divider number. Also a delta-sigma modulator may be provided to control the fractional-N divider based on a selected channel and data to be modulated. The delta-sigma modulator may vary the divider number of the fractional-N divider to cause the VCO to output a frequency spectrum.

According to another embodiment, a wireless transceiver is provided that may include a phase modulation (PM) path to control a voltage controlled oscillator (VCO) to generate a phase modulated frequency spectrum. An amplitude modulation (AM) path may be provided to control the gain or amplitude of the phase modulated frequency spectrum to generate a phase modulated and amplitude modulated output signal (transmit spectrum). A path delay adjustment circuit may be provided to detect a mismatch in a delay of the AM path and the PM path, or to determine whether the transmit spectrum meets one or more signal requirements, such as a spectral mask. The path delay adjustment circuit may adjust a delay or timing of at least one of the AM path and the PM path to provide a better match between the AM and PM paths.

In an example embodiment, modulation path calibration may be performed by inputting an amplitude and phase modulated transmit spectrum to the transceiver's receiver to be demodulated. The demodulated transmit spectrum may then be analyzed to determine if the transmit spectrum meets one or more signal requirements, such as falling within a required spectral mask. Or, the transmit spectrum may be analyzed to determine if there is a significant mismatch in the timing or delay between the AM path and PM path of the transmitter. The AM path delay and/or the PM path delay of the transmitter may be adjusted to decrease the mismatch in timing or delay between the AM path and PM path.

In another example embodiment, a wireless transceiver may include a transmitter. The transmitter may include a first modulation path to generate a first modulated frequency spectrum and a second modulation path to control the gain or amplitude of the first modulated frequency spectrum to generate a modulated output signal. The wireless transceiver may also include a path delay adjustment circuit to adjust a delay in at least one of the first and second modulation paths.

In yet another embodiment, a first modulation path in a transceiver is provided to perform a first modulation, and a second modulation path in the transceiver is provided to perform a second modulation to generate a transmit signal. The delay of the first and second modulation paths may be calibrated using a receiver of the transceiver. For example, the modulated transmit signal may be input or fed back into the receiver of the transceiver and demodulated. The demodulated signal may then be analyzed, and the delay path of the first modulation path and/or the second modulation path may be adjusted, e.g., to decrease any mismatch in the delay or timing of the first and second modulation paths.

According to an aspect of the invention, a wireless transceiver comprises:
a voltage controlled oscillator (VCO) to output one or more frequency signals;
a phase-locked loop (PLL) to control the VCO;
a fractional-N divider coupled to a feedback loop of the PLL to divide the frequency signal output by the PLL by a divider number;
a delta-sigma modulator to control the fractional-N divider based on a selected channel and data to be modulated, the delta-sigma modulator to vary the divider number of the fractional-N divider to cause the VCO to output a frequency spectrum.
Advantageously, the wireless transceiver further comprises a divider circuit coupled to an output of the VCO to produce a frequency spectrum at a different frequency than the frequency output by the VCO.
Advantageously, the wireless transceiver further comprises a digital modulator.
Advantageously, the PLL further comprises:
a phase frequency detector to compare a phase difference between a signal output from the fractional-N divider and a reference signal;
a charge pump to generate charge pulses based on a phase difference detected by the phase frequency detector; and
a programmable low pass filter to integrate charge pulses output by the charge pump to generate a voltage, the voltage output by the programmable low pass filter input to control the VCO.
Advantageously, the wireless transceiver further comprises:
a digital modulator to receive digital data and to output signals to a first path that includes the delta-sigma modulator, the fractional-N divider, the PLL and the VCO to generate a phase modulated signal output from the VCO according to the received digital data, the digital modulator also to output signals to a second path to provide amplitude modulation;
an amplifier to receive the phase modulated signal output from the VCO, the amplifier to amplitude modulate the phase modulated signal from the VCO according to signals from the digital modulator via the second path.
Advantageously, the wireless transceiver further comprises:
a digital modulator to receive digital data to be modulated and to output signals onto two paths, the digital modulator to receive a variable rate clock; and
a variable rate adapter coupled to the outputs of the digital modulator to compensate for the variable rate clock.
Advantageously, the wireless transceiver further comprises a frequency synthesizer circuit to generate a synthesizer frequency to be used as a reference frequency for the wireless transceiver.
According to an aspect of the invention, a wireless transceiver comprises:
a transmitter including:
   a phase modulation (PM) path to control a voltage controlled oscillator (VCO) to generate a phase modulated frequency spectrum; and
   an amplitude modulation (AM) path to control the gain or amplitude of the phase modulated frequency spectrum to generate a phase modulated and amplitude modulated output signal;
a path delay adjustment circuit to detect a mismatch in a delay of the AM path and PM path and to adjust a delay in at least one of the AM path or PM path.
Advantageously, the wireless transceiver further comprises:
a receiver to receive and demodulate signals, the receiver to received and demodulate the phase and amplitude modulated frequency spectrum output by the transmitter, the path delay adjustment circuit to analyze the demodulated transmitter frequency spectrum against a mask or other signal requirements and then to adjust the delay in at least one of the AM path and the PM path if the demodulated frequency spectrum does not meet the mask or the other signal requirements.
Advantageously, the wireless transceiver further comprises a mixer circuit to convert the frequency of the received transmitter frequency spectrum to a receiver frequency.
Advantageously, the wireless transceiver further comprises a plurality of mixer circuits to convert the frequency of the received transmitter frequency spectrum to a receiver frequency for each of a plurality of frequency bands.
Advantageously, the path delay adjustment circuit comprises an AM path delay adjustment circuit to detect a mismatch in a delay of the AM path and the PM path and to adjust a delay in the AM path to better match the delay in the PM path.
Advantageously, the AM path includes a digital-to-analog converter (DAC) to output analog signals based on received digital signals; and
the path delay adjustment circuit comprises an AM path delay adjustment circuit to detect a mismatch in a delay of the AM path and the PM path and to adjust a delay in the AM path to better match the delay in the PM path, the AM path delay adjustment circuit to adjust the AM path delay by adjusting the delay provided by the DAC in the AM path.
Advantageously, the PM path comprises:
a voltage controlled oscillator (VCO) to output one or more frequency signals;
a phase-locked loop (PLL) to control the VCO;
a fractional-N divider coupled to a feedback loop of the PLL to divide the frequency signal output by the PLL by a divider number;
a delta-sigma modulator to control the fractional-N divider based on a selected channel and data to be modulated, the delta-sigma modulator to vary the divider number of the fractional-N divider to cause the VCO to output a frequency spectrum.
Advantageously, the PLL comprises:
a phase frequency detector to compare a phase difference between a signal output from the fractional-N divider and a reference signal;
a charge pump to generate charge pulses based on a phase difference detected by the phase frequency detector; and
a programmable low pass filter to integrate charge pulses output by the charge pump to generate a voltage, the voltage output by the programmable low pass filter input to control the VCO.
According to an aspect of the invention, a method comprises:
generating a phase modulated frequency spectrum via a phase modulation (PM) path;
controlling a gain or amplitude of the phase modulated frequency spectrum via an amplitude modulation (AM) path to generate a phase and amplitude modulated frequency spectrum;
demodulating the phase and amplitude modulated frequency spectrum;
analyzing the demodulated spectrum; and
adjusting a delay or timing of at least one of the AM path and the PM path.
Advantageously, the method further comprises converting the frequency of the phase and amplitude modulated frequency spectrum to a receiver frequency before demodulating the frequency spectrum.
Advantageously, the analyzing comprises analyzing the demodulated spectrum to determine if the demodulated spectrum meets one or more signal requirements; and
wherein the adjusting comprises adjusting a delay or timing of the AM path and/or the PM path if the demodulated spectrum does not meet the one or more signal requirements.
Advantageously, the analyzing comprises analyzing the demodulated spectrum to determine if there is a significant mismatch in delay in the AM path and the PM path; and
wherein the adjusting comprises adjusting a delay or timing of the AM path and/or the PM path to improve the mismatch between the delays of the AM path and PM path.
Advantageously, the analyzing comprises analyzing the demodulated spectrum to determine if the demodulated spectrum meets a spectral mask.

### BRIEF DESCRIPTION OF THE DRAWINGS

FIG. 1 is a block diagram of a wireless system according to an example embodiment.

FIG. 2 is a block diagram of a wireless transceiver according to an example embodiment.

FIG. 3 is a diagram illustrating an example spectral mask.

FIG. 4 is a flow chart illustrating operation of a wireless transceiver according to an example embodiment.

### DETAILED DESCRIPTION

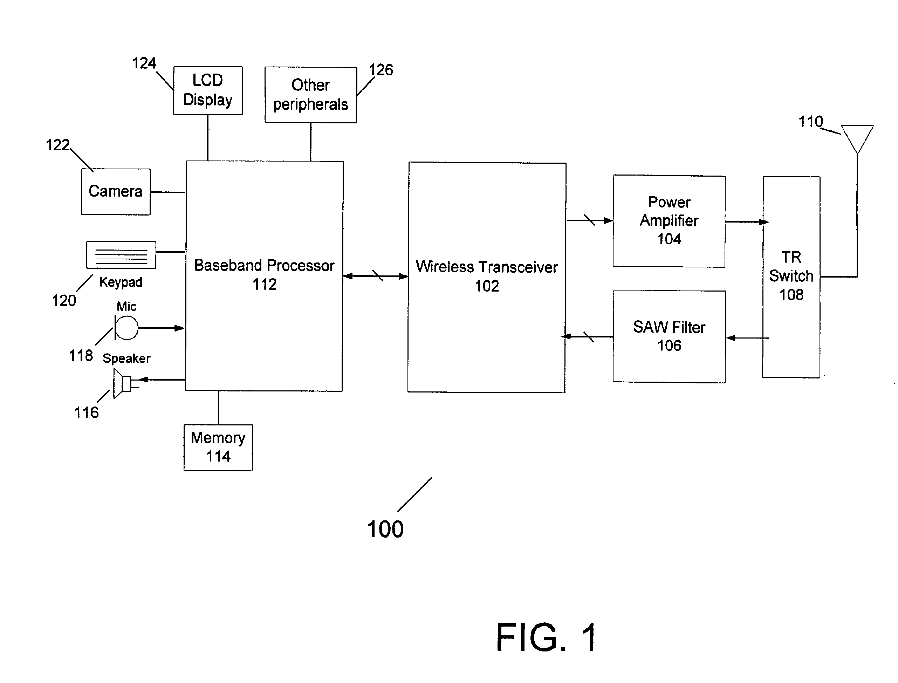

FIG. 1 is a block diagram of a wireless system according to an example embodiment. Wireless system 100 may include a wireless transceiver (transmitter/receiver) 102 for transmitting and receiving radio or wireless signals. A baseband processor 112 is coupled to wireless transceiver 110 to perform various types of processing and overall control of system 100, and may perform other tasks. Baseband processor 112 may include a controller, and may include for example, an audio codec to process audio signals, a video or image processing codec (e.g., an MPEG4 compression and/or decompression module), and other components or blocks, not shown.

An antenna 110 may be provided to receive and transmit radio signals or electromagnetic signals. A transmitter/receiver (TR) switch 108 may select either the transmit or receive mode for the antenna 110. Signals output by wireless transceiver 102 to be transmitted may be amplified by amplifier 104 and then transmitted via antenna 110. Signals received via antenna 110 may be filtered by a SAW (surface acoustic wave) filter 106 (or other filter) and then input to transceiver 102. At transceiver 102, the received signals may be processed or demodulated, which may include down-converting the signals to an intermediate frequency (IF) and then down-converting to baseband or other frequency, digital detection of data and other signal processing. Likewise, digital data to be transmitted may be received by transceiver 102 from baseband processor 112. Wireless transceiver 110 may modulate the digital data from baseband processor 112 onto a selected channel or frequency (or range or spectrum of frequencies) for transmission over antenna 110.

A variety of blocks or peripherals may be coupled to baseband processor 112. For example, a memory 114, such as a Flash memory or Random Access Memory (RAM), may store information. A microphone 118 and speaker 116 may allow audio signals to be input to and output by wireless system 100, such as for a cell phone or other communications device. A keypad 120 may allow a user to input characters or other information to be processed by wireless system 100. A camera 122 or other optical device may be provided to allow users to capture photos or images that may be processed and/or stored by system 100 in memory or other storage location. Wireless system 100 may also include a display 124, such as a liquid crystal display for example, to display information (text, images, etc.). A variety of other peripherals 126 may be coupled to baseband processor 112, such as a memory stick, an audio player, a Bluetooth wireless transceiver, a USB (Universal Serial Bus) port, or other peripheral. These are merely a few examples of the types of devices or peripherals that may be provided as part of wireless system 100 or coupled to baseband processor 112, and the disclosure is not limited thereto.

Wireless system 100 may be used in a variety of systems or applications, such as a mobile or cellular phone, a wireless local area network (WLAN) phone, a wireless personal digital assistant (PDA), a mobile communications device, or other wireless device. In an example embodiment, wireless system 100 may be capable of operating in a variety of transmit/receive frequencies or frequency bands and for a variety of different standards or communications protocols. Although not required, wireless system 100 may be a multi-band wireless system capable of transmitting or receiving signals on one of a plurality of frequencies or bands. For example, wireless system 100 may operate at or around 1900 MHz for WCDMA (Wide-Band Code Division Multiple Access) or PCS (Personal Communications Services), at or around 1800 MHz for DCS (Distributed Communication Services) (these frequencies may be considered an upper band of frequencies), at 850 MHz for GSM (Global System for Mobile communication), at or around 900 MHz for EGSM (Extended GSM) (these frequencies may be considered a lower band of frequencies). These are merely some example frequencies, and the system 100 may operate at many other frequencies and standards.

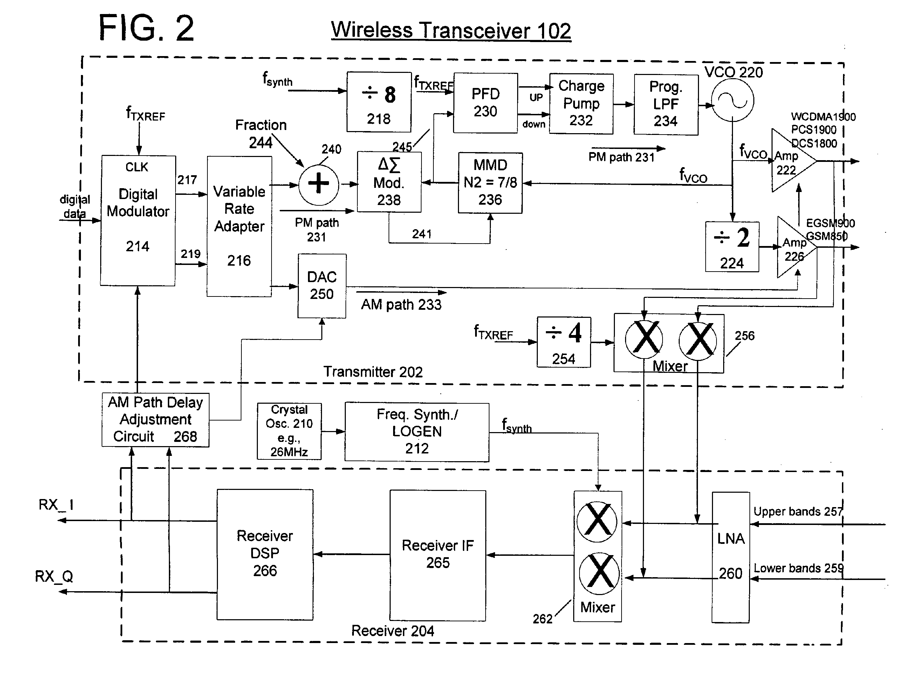

FIG. 2 is a block diagram of a wireless transceiver according to an example embodiment. Wireless transceiver 102 may include a transmitter 202 to modulate and transmit data, and a receiver 204 to receive and demodulate data. A crystal oscillator 210 may generate a signal at a constant frequency, such as 26 MHz or other frequency (26 MHz is merely an example and other frequencies may be used). A frequency synthesizer/local oscillator generator (LOGEN) circuit 212 may generate a synthesized frequency signal (f_{synth}) at a selected one of a plurality of frequencies. The synthesized frequency signal (f_{synth}) may be used by both the transmitter 202 and receiver 204 as a reference signal.

A digital modulator 214 may receive digital data and output data onto one or more paths. According to an example embodiment, transmitter 102 may modulate received data using a variety of Phase Shift Keying (PSK), such as 8PSK, Quadrature Amplitude Modulation (QAM), etc., in which data may be modulated using both phase modulation and amplitude modulation. Digital modulator 214 may alternatively modulate received data using phase modulation or frequency modulation, or variations thereof, such as Gaussian-Filtered Minimum Shift Keying (GMSK), and the like. According to an example embodiment, for such a phase modulation or frequency modulation or GMSK modulation, or the like, the amplitude of the signal output by transmitter 202 may be, for example, set to a constant amplitude or level.

To be able to accommodate different frequencies and different channels, f_{synth} may be a variable frequency between, for example, 1.752 GHz and 2.0 GHz. This is merely an example frequency range, and other frequencies or frequency ranges may be used. f_{synth} may be frequency divided by frequency divider 218 to generate a transmit reference frequency (f_{TXREF}) . In an example embodiment, frequency divider 218 may be a divide by 8. Therefore, f_{TXREP} may be generated as f_{synth}/8, in such case, f_{TXREF} may vary between 219 MHz and 250 MHz, for example.

Digital modulator 214 may receive digital data and output signals on both lines 217 and 219 to a variable rate adapter 216. In an example embodiment, digital modulator 214 may use f_{TXREF} as a clock. As noted, f_{TXREF} may be a variable frequency. Variable rate adapter 216 may compensate for the variable rate clock (f_{TXREF}) that may be used by digital modulator 214, e.g., such that signals output by variable rate adapter 216 may be output at a constant frequency even though clock for digital modulator 214 may vary.

In order to perform both phase modulation (PM) (or a variation thereof) and amplitude modulation (AM) on the received digital data, such as for 8PSK or QAM or the like, variable rate adapter 216 may output signals onto two paths including: 1) a PM path 231 to perform phase modulation based on received data; and 2) an AM path 233 to perform amplitude modulation based on the received data.

The PM path will now be discussed. A voltage controlled oscillator (VCO) 220 may output a signal at an operating frequency for a selected channel for a selected band of a service (e.g., channel number 2 at a center frequency of 1710.2 MHz for DCS). For example, a base station or Access Point (AP) may assign the wireless system 100 a channel to use for data transmission. As described in more detail below, VCO 220 may output a range of frequencies or a frequency spectrum for the selected channel, with the data being modulated onto the frequency spectrum. VCO 220 may also include a gain, or an amount which the output spectrum from VCO 220 is amplified. This gain (K) of VCO 220 may be referred to as Kvco. In an example embodiment, the gain of VCO 220 (Kvco) may be calibrated.

The frequency spectrum output by VCO 220 may then be amplified by upper band amplifier 222 for transmission via antenna 110. The frequency spectrum output by VCO 220 may also be divided by two by frequency divider 224 and then amplified by lower band amplifier 226 for data transmission over antenna 110. Thus, according to an example embodiment, a frequency spectrum for a selected channel in the upper band of frequencies may be amplified and output by amplifier 222, while a frequency spectrum for a selected channel in the lower band of frequencies may be amplified and output by amplifier 226.

According to an example embodiment, a phase-locked loop (PLL) may control or lock the VCO 220 to the desired or selected operating frequency (channel). The PLL may include, for example, a phase-frequency detector (PFD) 230, a charge pump 232 and a programmable low pass filter (LPF) 234, and may include other or different components, since this is merely an example PLL. The output (f_{VCO}) of VCO 220 may include an operating frequency of a selected channel (e.g., center frequency). A fractional-N frequency divider 236 is coupled to the feedback loop of the PLL. The output of VCO 220 (fvco) is divided by a divider number (N2) of frequency divider 236 that is selected by a 1-bit delta-sigma (ΔΣ) modulator 238. Frequency divider 236 may be considered to be a multi-modulus divider (MMD) since the divider may be one of multiple different numbers. The frequency divider 236 may also be considered a fractional-N divider since it may divide the received frequency (f_{VCO}) by an overall fractional divider number (e.g., between two integer numbers) by varying the selected divider number used by divider 236.

In an example embodiment, the divider number (N2) used by divider 236 may be either 7 or 8, based on the signal (bit) received from delta-sigma modulator 238 via line 241 (e.g., a 0 output on line 241 by modulator 238 to indicate a 7 for the divider N2, while a 1 indicating an 8 for divider N2). Therefore, according to an example embodiment, the operating frequency output by VCO 220 may be f_{VCO} = N2* f_{TXREF}. The divider numbers (N2) of 7 or 8 may allow only two operating frequencies to be output by VCO 220 for a particular f_{TXREF} (transmitter reference frequency). However, by varying the selected divider number (N2) used by divider 236, almost any fractional divider number between 7 and 8 may be obtained, which may allow VCO 220 to output a range of frequencies.

In order to lock or control the VCO 220 to a desired to selected output frequency (for the selected channel), a f_{synth} (and thus f_{TXREF}) is selected, and a fractional divider number is selected between 7 and 8 (in this example embodiment, although any numbers may be used) that will provide the selected operating frequency output by VCO 220. For example, if a transmit operating frequency is assigned or selected of 1.661 GHz, then a transmit reference frequency (f_{TXREF}) may be selected of 220 MHz, and a fractional divider number of 7.55 may be used. Thus, in this example, a VCO output (operating frequency for the channel) is thus obtained as: f_{VCO} = N2 (average) * f_{TXREF}, which in this case may be calculated as: f_{VCO} = 7.55 * 220 MHz = 1.661 GHz, which is the desired operating frequency (e.g., center frequency for the assigned transmission channel).

The fractional divider number (7.55 in this example) between 7 and 8 may be obtained by using delta sigma modulator 238 to vary the divider number (N2) of divider 236 to divide by 7 and divide by 8 an appropriate amount or percentage to obtain the selected fractional divider number. For example, to obtain a fractional divider number of 7.5, then the divider 236 would divide by 7 half of the time, and divide by 8 the other half of the time (50% duty cycle, half zeroes, half ones). By changing the duty cycle or percentage of zeros and ones output by delta sigma modulator 238 via line 241, the frequency (fvco) received via line 243 may be divided by a selected fractional divider number (e.g., 7.55).

The fractional portion (0.55 in this example) of the selected fractional divider number (7.55 in this example) may be input to combiner 240. Combiner 240 may add or combine the fraction 244 (0.55 in this example) with a data signal (to provide phase modulation) output by variable rate adapter 216. The output of combiner 240 may control delta-sigma modulator 238 to obtain the (overall) selected fractional divider number for fractional-N divider 236.

In an example embodiment, VCO 220 may not necessarily output a single tone or frequency, but rather, may output a phase modulated frequency spectrum. In an example embodiment, the delta sigma modulator 236 may control the fractional-N divider 238 to vary the divider number (N2) around the selected fractional divider number so as to cause VCO 220 to generate a phase modulated frequency spectrum. In part, the delta sigma modulator 238 may be controlled based on signals output via line 217 from digital modulator 214 (e.g., to allow phase modulation of the output signal output from VCO 220), and passed through (e.g., after compensation) by variable rate adapter 216. This may allow the output from VCO 220 (fvco) to be a phase modulated frequency spectrum around a center frequency for the selected channel (the operating frequency selected by the fractional divider number, such as 7.55, for example).

An operation of the example PLL of transmitter 202 will be briefly described. The transmitter reference frequency (f_{TXREF}) is input as a reference signal to PFD 230. The divided frequency signal output on line 245 from divider 236 is a second input to PFD 230. PFD 230 may generate an output signal(s) based on the phase difference between its two input signals. For example, an up signal or a down signal may be output by PFD 230 based on whether the divided frequency signal on line 245 leads or lags the reference frequency signal (f_{TXREF}), respectively. Charge pump 232 may generate positive or negative charge pulses based on whether the divided frequency signal on line 245 leads or lags the reference signal (f_{TXREF}), respectively. Programmable low pass filter (LPF) 234 may integrate or accumulate the charge pulses to generate a voltage, which, for example, may indicate the amount that the divided frequency signal on line 245 leads or lags the reference signal (f_{TXREF}). The voltage output by LPF 234 may control or adjust the frequency (fvco) output by VCO 220.

Thus, via the PM path 231, VCO 220 may output a phase modulated frequency spectrum, which is then amplified and output by upper band amplifier 222. Similarly, the output from VCO 220 is divided by two by divider 224, and is then amplified and output by lower band amplifier 226.

In an example embodiment, LPF 234 (of the PLL) may set the loop bandwidth of the PLL. If the bandwidth of the LPF is too narrow, part of the output spectrum from VCO 220 may be clipped or distorted. Likewise, if the bandwidth of LPF 234 is too wide, this may introduce an unacceptable amount of noise into the system. Therefore, according to an example embodiment, a relatively narrow bandwidth may be used for LPF 234, such as 200KHz (this is merely an example, and other bandwidths may be used). Also, in an example embodiment, digital modulator 214 may include an equalizer to account for some clipping or signal distortion that may occur due to the 200 KHz bandwidth of low pass filter (LPF) 234. In an example embodiment, LPF 234 may be an R-C (resistor-capacitor) filter, which may be calibrated.

In cases in which the transmitted signal may be both phase modulated and amplitude modulated, such as for 8PSK, QAM or the like, the AM path 231 may perform amplitude modulation on the phase modulated spectrum based on the received digital signals. As noted, the digital data is received by digital modulator 214. The digital modulator 214 may output data via two paths, to provide both phase modulation (via PM path 231) and amplitude modulation (via AM path 233).

The AM path 233 will now be briefly described. Digital modulator 214 outputs signals (e.g., via variable rate adapter 216) to digital-to-analog converter (DAC) 250. DAC converts received digital signals to analog signals. The analog signals, which may represent or indicate an amplitude, are input to amplifiers 226 and 222. Amplifiers 226 and 222 may amplitude modulate (or vary the amplitude) of the phase modulated spectrum provided from the VCO 220 based upon the signals received from DAC 250 via AM path 233. Thus, signals received via the AM path 233 may control the amplitude or gain of the phase modulated signals (spectrum) output by transmitter 202. Therefore, amplifiers 222 and 226 may output an amplitude and phase modulated signal (e.g., frequency spectrum), according to an example embodiment.

In cases where only phase or frequency modulation is performed (such as, for example, GMSK for GSM and EGSM), then the amplitude value output by digital modulator 214 to DAC 250 may be set to a constant level, to provide a constant amplitude for the phase modulated spectrum output by amplifiers 222 and 226. In an embodiment, the constant amplitude used by DAC 250 for such modulations may be typically set to a maximum to provide a high saturated output power.

Receiver 204 of wireless transceiver 102 (FIG 2) will now be briefly described. Wireless signals may be input to receiver 204, including upper (or high) band signals received via line 257, and lower band signals received via line 259. These received signals may be amplified by low noise amplifier (LNA) 260. During normal operation, the received wireless signal may be down converted by mixer 262, based on the synthesizer frequency (f_{synth}) output by LOGEN circuit 212 (e.g., the received signal may be mixed with f_{synth} by mixer 262 to generate an IF signal.). In an embodiment, the received signal may then be down converted to an intermediate frequency (IF) of 200 KHz, for example (although any frequency may be used for IF). The IF signal may be input to receiver IF block 265 (which may include, for example, filters, gain control and other circuits) where IF processing is performed. The signals output by receiver IF block 265 are input to a receiver DSP 266, which may include, for example, gain control and digital signal processor to down convert the IF signal to baseband. Receiver DSP 266 may output in-phase and quadrature-phase receive signals (RX_I, Rx_Q, respectively). The receive signals (RX_I and RX_Q) may also be output to digital modulator 214 (connection not shown), and also to an AM path delay adjustment circuit 268.

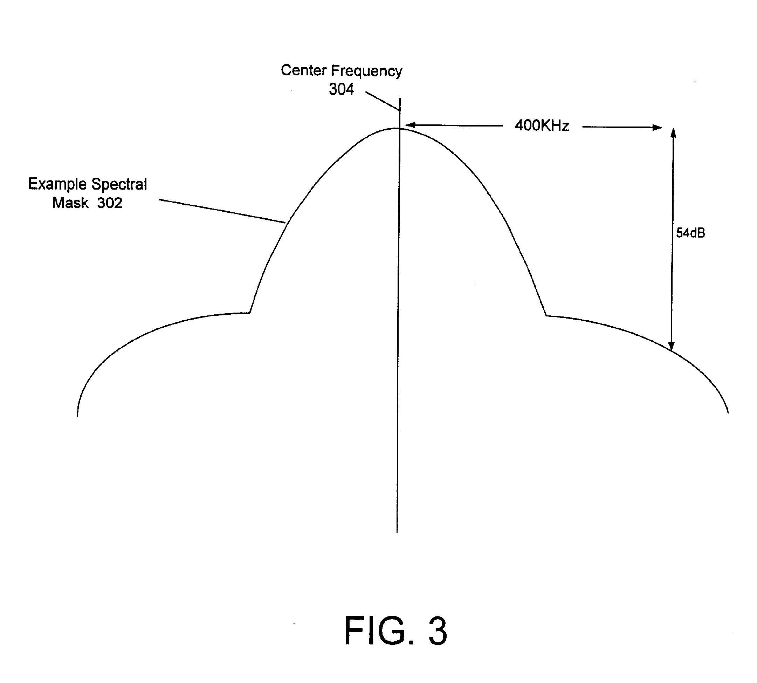

Wireless systems, at least in some cases, may be required to meet one or more signal requirements. For example, some wireless technologies may require wireless transmissions meet (or fall within) a spectral mask. FIG. 3 is a diagram illustrating an example spectral mask. In an example embodiment, wireless transmissions from a wireless system (such as wireless system 100) may be required to meet or fall within the spectral mask 302. For example, one requirement of such a spectral mask 302 may include that the transmitted signal that is 400 KHz from the center frequency 304 be at least 54dB below the peak amplitude at the center frequency 304. This is merely an example of a signal requirement that wireless system 100, or other system, may be required to meet.

One issue that may arise for wireless systems that employ two types of modulation, such as both amplitude and phase or frequency modulation (e.g., such as 8PSK, QAM, etc.) is that there may be a mismatch in the timing or delay for the phase modulation and amplitude modulation (or more generally, a mismatch in the delay of a first modulation path and a second modulation path). In some cases, if the mismatch in delay or timing through the AM path and PM path of the transceiver is significant, it may distort the output or transmitted signal such that the output signal does not meet one or more signal requirements (such as a spectral mask). Therefore, for example, to avoid violating a spectral mask or other signal requirements, it may be desirable for the delay (or timing) through the AM path 231 and PM path 233 to be well matched.

According to an example embodiment, the receiver 204 of transceiver 102 may be used to calibrate the delay or timing for the AM path 231 and PM path 233 of transmitter 202. The transmitter reference frequency f_{TXREF} may be divided by four by frequency divider 254. This divided signal (f_{TXREF}/4) may be input to mixer 256. Mixer 256 may up-convert the frequency of the modulated transmit frequency spectrum (amplitude and phase modulated output spectrum from amplifiers 222 and 226) to receive frequencies (e.g., upper and/or lower band receive frequencies that can be processed by receiver 204). During delay path calibration node, the up-converted modulated transmit frequency spectrum is then fed or input to receiver 204 for processing. The transmit frequency spectrum may be down converted by mixer 262 to IF (e.g., 200KHz), and processed by receiver IF block 265 and receiver DSP 266. The processed (or demodulated) transmit spectrum may then be output via receive signals (RX_I and RX_Q). This processing of the signals at receiver 204 may be considered to be a form of demodulation, in an example embodiment.

The processed or demodulated transmit spectrum may then be analyzed by AM path delay adjustment circuit 268, e.g., to determine if the demodulated transmit spectrum meets one or more signal requirements, such as determining if the demodulated transmit spectrum meets or falls within a required spectral mask. Alternatively, path delay adjustment circuit 268 may determine if there is a significant mismatch between the timing or delay of the AM path 233 and PM path 231, for example. Path delay adjustment circuit 268 may then adjust the delay or timing of one or both of the AM path 233 and PM path 231, e.g., if the demodulated (or processed) transmit spectrum does not meet the one or more signal requirements or mask, or if there is a significant mismatch in the timing or delay between the AM path 233 and PM path 231, for example. Path delay adjustment circuit 268 may adjust the delay or timing of the AM path 233 or the PM path 231, or both.

In another example embodiment, the gain of VCO 220 may be calibrated. In such case, in an example embodiment, the loop bandwidth of the PLL and LPF 234 may be well defined, and the delay through the PLL (PM path) and the AM path may also be stable and well defined. As a result, this is one example where it may not be necessary to calibrate the modulation delay paths (AM and PM paths). Thus, in an example embodiment, the modulation path delay calibration may be optional, and may be disabled or turned of in some cases.

In an example embodiment, path delay adjustment circuit 268 may be an AM path delay adjustment circuit that may adjust the delay of the AM path 233, based on the analysis or evaluation of the demodulated transmit spectrum (e.g., if the demodulated spectrum does not meet the signal requirement or mask). For example, path delay adjustment circuit 268 may adjust the delay provided by DAC 250 in AM path 233. This process may be repeated and re-calibrated, e.g., another modulated transmit frequency spectrum signal may be up-converted by mixer 256 to the receive frequency, and input to the receiver 204, where the spectrum may be down converted to IF, down converted to baseband and processed (e.g., demodulated). The demodulated or receive-processed transmit spectrum may again be evaluated or analyzed, and then a delay or timing may be adjusted in one or both AM path 233 and PM path 231, if necessary, to improve the match in path delay or improve the quality of the output signal. In this manner, the AM path delay and PM path delay of transmitter 202 may be calibrated (e.g., measured and adjusted) by feeding the modulated transmit spectrum into the receiver 204 for processing.

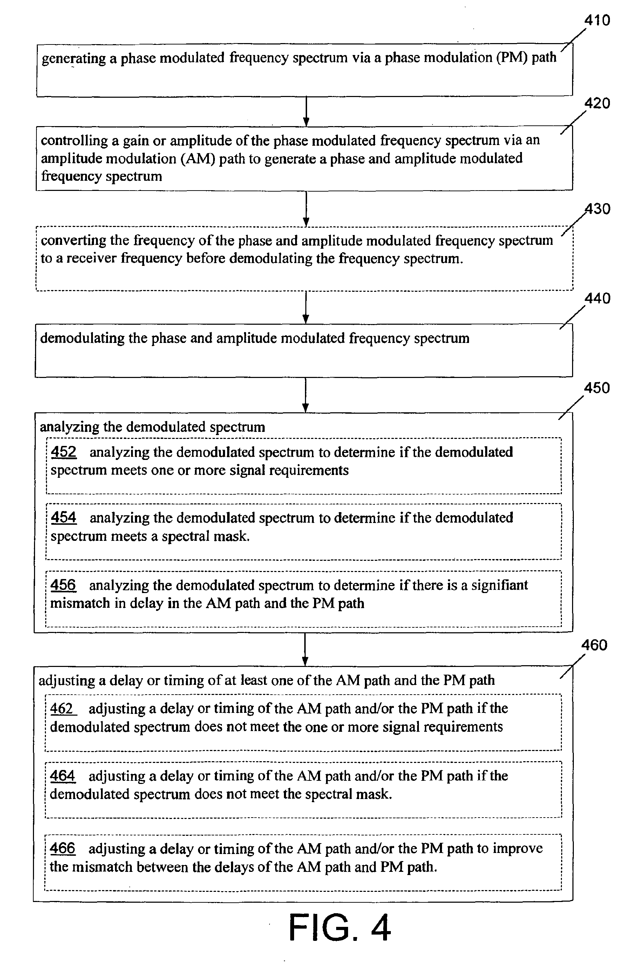

FIG. 4 is a flow chart illustrating operation of a wireless transceiver according to an example embodiment. At 420, a gain or amplitude of the phase modulated (transmit) frequency spectrum may be controlled via an amplitude modulation (AM) path to generate a phase and amplitude modulated frequency spectrum. At 430, the frequency of the phase and amplitude modulated frequency spectrum may be converted to a receiver frequency. At 440, the (converted) phase and amplitude modulated (transmit) frequency spectrum may be receive-processed or demodulated.

At 450, the demodulated or receive-processed frequency spectrum may be analyzed or evaluated. This may include, for example, analyzing the processed or demodulated transmit spectrum to determine if the spectrum meets one or more signal requirements (452), or analyzing the demodulated spectrum to determine if the demodulated spectrum meets the spectral mask (454) or determining if there is a significant mismatch between the delay of the AM path and the PM path (456).

At 460, the delay or timing of at least one of the AM path and the PM path may be adjusted. For example, this may include adjusting a delay or timing of the AM path and/or PM path if the demodulated spectrum does not meet the one or more signal requirements (462), or adjusting a delay or timing of the AM path and/or PM path if the demodulated spectrum does not meet the spectral mask (464), or adjusting a delay or timing of the AM path and/or PM path to improve a mismatch between the delays of the AM path and the PM path (466).

While certain features of the described implementations have been illustrated as described herein, many modifications, substitutions, changes and equivalents will now occur to those skilled in the art. It is, therefore, to be understood that the appended claims are intended to cover all such modifications and changes as fall within the true spirit of the various embodiments.

## Claims

1. A wireless transceiver comprising:
a voltage controlled oscillator (VCO) to output one or more frequency signals;
a phase-locked loop (PLL) to control the VCO;
a fractional-N divider coupled to a feedback loop of the PLL to divide the frequency signal output by the PLL by a divider number;
a delta-sigma modulator to control the fractional-N divider based on a selected channel and data to be modulated, the delta-sigma modulator to vary the divider number of the fractional-N divider to cause the VCO to output a frequency spectrum.

2. The wireless transceiver of claim 1 and further comprising a divider circuit coupled to an output of the VCO to produce a frequency spectrum at a different frequency than the frequency output by the VCO.

3. The wireless transceiver of claim 1 and further comprising a digital modulator.

4. The wireless transceiver of claim 1 wherein the PLL further comprises:
a phase frequency detector to compare a phase difference between a signal output from the fractional-N divider and a reference signal;
a charge pump to generate charge pulses based on a phase difference detected by the phase frequency detector; and
a programmable low pass filter to integrate charge pulses output by the charge pump to generate a voltage, the voltage output by the programmable low pass filter input to control the VCO.

5. The wireless transceiver of claim 1 and further comprising:
a digital modulator to receive digital data and to output signals to a first path that includes the delta-sigma modulator, the fractional-N divider, the PLL and the VCO to generate a phase modulated signal output from the VCO according to the received digital data, the digital modulator also to output signals to a second path to provide amplitude modulation;
an amplifier to receive the phase modulated signal output from the VCO, the amplifier to amplitude modulate the phase modulated signal from the VCO according to signals from the digital modulator via the second path.

6. A wireless transceiver comprising:
a transmitter including:
a phase modulation (PM) path to control a voltage controlled oscillator (VCO) to generate a phase modulated frequency spectrum; and
an amplitude modulation (AM) path to control the gain or amplitude of the phase modulated frequency spectrum to generate a phase modulated and amplitude modulated output signal;
a path delay adjustment circuit to detect a mismatch in a delay of the AM path and PM path and to adjust a delay in at least one of the AM path or PM path.

7. The wireless transceiver of claim 6 and further comprising:
a receiver to receive and demodulate signals, the receiver to received and demodulate the phase and amplitude modulated frequency spectrum output by the transmitter, the path delay adjustment circuit to analyze the demodulated transmitter frequency spectrum against a mask or other signal requirements and then to adjust the delay in at least one of the AM path and the PM path if the demodulated frequency spectrum does not meet the mask or the other signal requirements.

8. A method comprising:
generating a phase modulated frequency spectrum via a phase modulation (PM) path;
controlling a gain or amplitude of the phase modulated frequency spectrum via an amplitude modulation (AM) path to generate a phase and amplitude modulated frequency spectrum;
demodulating the phase and amplitude modulated frequency spectrum;
analyzing the demodulated spectrum; and
adjusting a delay or timing of at least one of the AM path and the PM path.

9. The method of claim 8 and further comprising converting the frequency of the phase and amplitude modulated frequency spectrum to a receiver frequency before demodulating the frequency spectrum.

10. The method of claim 8 wherein the analyzing comprises analyzing the demodulated spectrum to determine if the demodulated spectrum meets one or more signal requirements; and
wherein the adjusting comprises adjusting a delay or timing of the AM path and/or the PM path if the demodulated spectrum does not meet the one or more signal requirements.
